Europäisches Patentamt

European Patent Office

Office européen des brevets

(11) Publication number: **0 098 114**
**B1**

# EUROPEAN PATENT SPECIFICATION

(45) Date of publication of patent specification: **02.03.88**

(51) Int. Cl.⁴: **H 01 L 23/48** // H01L23/04

(21) Application number: **83303642.9**

(22) Date of filing: **24.06.83**

(54) **Leadless chip carrier semiconductor integrated circuit device.**

(30) Priority: **29.06.82 JP 98790/82 u**

(43) Date of publication of application:
**11.01.84 Bulletin 84/02**

(45) Publication of the grant of the patent:
**02.03.88 Bulletin 88/09**

(84) Designated Contracting States:
**DE FR GB**

(56) References cited:
**GB-A-2 056 772**

**IEEE TRANSACTIONS ON COMPONENTS, HYBRIDS & MANUFACTURING TECHNOLOGY, vol. CHMT-4, no. 2, June 1981, pages 200-205, IEEE, New York, US; T.M. SHELTON: "Testing of properties for soldered leadless chip carrier assemblies"**

(73) Proprietor: **FUJITSU LIMITED**
**1015, Kamikodanaka Nakahara-ku**
**Kawasaki-shi Kanagawa 211 (JP)**

(72) Inventor: **Tsujimura, Takehisa**
**Sebun-20, 197, Kitamikata Takatsu-ku**
**Kawasaki-shi Kanagawa 213 (JP)**

(74) Representative: **George, Sidney Arthur et al**
**GILL JENNINGS & EVERY 53-64 Chancery Lane**
**London WC2A 1HN (GB)**

Courier Press, Leamington Spa, England.

EP 0 098 114 B1

## Description

This invention relates to a semiconductor device, and more particularly to a leadless chip carrier (LCC) type semiconductor integrated circuit device.

Recently, the demand for LCCs has increased due to miniaturization of electronic devices, and for convenience of handling and dense packing. An LCC is a small package having a cavity in which a semiconductor chip is mounted in contact with a plated gold layer. Instead of external leads, it has soldering pads or bumps for electrical connection with external parts on a substrate. The soldering pads are electrically connected to the semiconductor chip via metallization lines. Such metallization lines run radially from the portion adjacent the semiconductor chip to the edges of the package, turn down at the edges, extend down the walls of a plurality of parallel grooves which are spaced apart round the periphery of the package, and so reach the soldering pads which are formed on the underside of the package. Such a leadless chip carrier is described in IEEE Transactions on Components, Hybrids and Manufacturing Technology, Vol. CHMT-4, No. 2, June 1981, pages 200—205.

In such an LCC device, dense packing becomes difficult if the degree of integration of the circuit increases, since an increase in the number of external leads or soldering pads makes the external size of the package larger. Shortening the pitch of the soldering pads to avoid the above-mentioned problem causes short circuits due to the formation of solder bridges between adjacent soldering pads when the device is assembled on to an external substrate, since the soldering pads are arranged in a line along the edge of the underside of the package. This limits the amount by which the pitch of the soldering pads can be shortened, thereby inhibiting higher-density integration of the device.

It is, therefore, an object of the present invention to permit the production of a semiconductor device having a higher degree of integration by providing a denser LCC with an increased number of soldering pads for a given package size.

According to the invention a semiconductor device comprising a semiconductor chip; a ceramic base carrying the semiconductor chip thereon and having a plurality of grooves spaced apart along the edge face of the base; a respective metallization line formed on the wall of each groove and electrically connected to the chip; and a plurality of soldering pads formed on the underside of the base and electrically connected to the metallization lines is characterised in that adjacent grooves have different depths measured from the edge face of the base.

In a semiconductor device according to the invention, short circuits due to solder bridges between adjacent soldering pads can be avoided even though the pitch of the metallization lines to which the soldering pads are connected is small, because the soldering pads can be spaced apart further than the space between the metallization lines, due to the different distances of the soldering pads from the periphery of the ceramic base. Further, if there is a defect in the soldering when an LCC type semiconductor device according to the invention is packaged on to an external circuit board, the defect can be easily found because soldered portions between the device and the board can be viewed externally through grooves which are cut away from the periphery of the device. If metallization lines are formed by means of through holes, the soldered portions between the device and the board cannot be viewed externally. Furthermore, in an LCC type semiconductor device according to the invention, the metallization lines may be plated so that the electrical resistance between the soldering pads and a semiconductor chip is reduced. If the metallization lines are formed by means of through holes, the metal used in filling the through holes should be one, such as tungsten, which is resistant to the high temperature used in firing green sheets. The use of such metal results in a high electrical resistance.

Embodiments of the invention will now be described, by way of example, with reference to the accompanying drawings, in which

Fig. 1 is a sectional view of a prior art semiconductor device,

Fig. 2 is an exploded view of the main parts of a package of the semiconductor device of Fig. 1,

Fig. 3 is an underneath plan view of the semiconductor device of Fig. 1,

Fig. 4 is a sectional view of a semiconductor device according to the present invention,

Fig. 5 is an exploded view of the main parts of a package of the semiconductor device of Fig. 4,

Fig. 6 is an underneath plan view of the semiconductor device of Fig. 4, and

Fig. 7 is a partial underneath plan view of another semiconductor device according to the present invention.

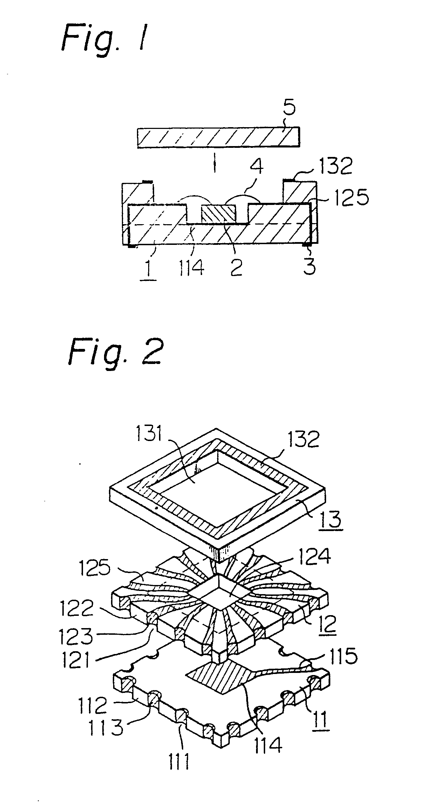

Figs. 1 to 3 illustrate a prior art LCC type semiconductor device. A ceramic base 1 made of, for example, alumina is constructed from three plates, i.e. a ceramic base plate 11, a ceramic intermediate plate 12, and a ceramic top plate 13. The base and intermediate plates 11 and 12 have a plurality of spaced-apart half-round grooves 111 and 121 formed along the side peripheries 112 and 122 thereof. The width (or diameter) and the depth of the half-round grooves are 0.4 mm and 0.2 mm respectively. The pitch of the grooves 111 and 121 is 1.27 mm. On the surfaces of the walls of the grooves 111 and 121, metallization lines 113 and 123, respectively, are formed.

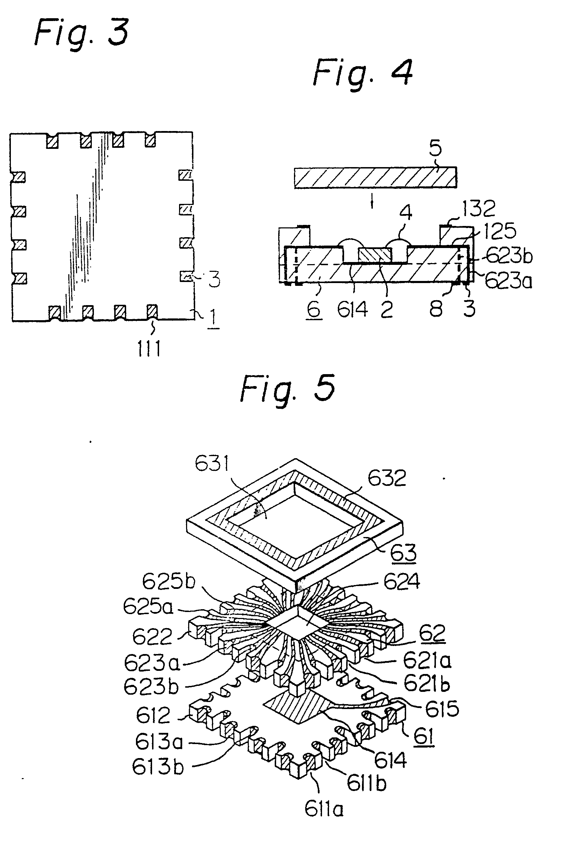

The base plate 11 has metallization layers or soldering pads 3 (Fig. 3) on its underside, electrically connected to the metallization lines 113.

In the central portion of the base plate 11 a metallization layer 114 is formed for receiving a semiconductor chip 2. The metallization layer 114 is electrically connected to a respective one of the metallization lines 113 via a metallization line 115 formed on the base plate 11.

The intermediate plate 12 has a square aperture or cavity 124 at its central portion, corresponding to the metallization layer 114 thereunder, and a plurality of radial metallization lines 125, each of which is electrically connected to a respective one of the metallization lines 123.

The top plate 13 has a large aperture 131 at its central portion and a metallization layer 132 for sealing a cap 5 to the ceramic body.

The three ceramic plates 11, 12 and 13 are laminated together and fired at a high temperature to obtain a sintered ceramic body or base 1. The metallization lines 113 of the base plate 11 and the metallization line 123 of the intermediate plate 12 are connected to each other by the above-mentioned lamination and firing. Usually, in an LLC as mentioned above, the surfaces of the metallization layers 113, 114, 115, 123, 124, 125, 132 and 3 are covered with platings of nickel, gold etc.

A semiconductor chip 2 is welded on to the exposed part of the metallization layer 114 of the centre portion of the ceramic base plate 11. Fine metal wires 4 are used for connecting the semiconductor chip 2 to respective metallization lines 125 on the intermediate plate 12. The cap 5 is bonded on to the metallization layer 132 of the top plate 13 with low melting point solder.

In the device, the pitch of the soldering pads 3 is 1.27 mm. If, for example, the number of soldering pads 3 is doubled without changing the size of the package, the pitch of the soldering pads becomes 0.635 mm.

Figs. 4 to 6 illustrate an example of a semiconductor device according to the invention. The device includes a semiconductor chip 2, soldering pads 3, fine wires 4 and a cap 5, as in the prior art device described above.

A ceramic base 6 is constructed from three plates, i.e. a base plate 61, an intermediate plate 62, and a top plate 63. The base and intermediate plates 61 and 62 each have two sets of grooves, one being shallow and the other deep. The shallow grooves 611a and 621a are 0.2 mm in depth and 0.4 mm in width. The deep grooves 611b and 621b are 1.47 mm in depth and 0.4 mm in width. These two sets of grooves are arranged alternately along the side edges 612 and 622 of the base and intermediate plates 61 and 62, respectively. The pitch of the grooves is 0.635 mm.

The intermediate plate 62 has a square aperture or cavity 624 at its central portion. The top plate 63 has a square aperture or cavity 631 at its centre and a metallization layer 632 on its upper side for bonding the cap 5 to the base 6.

The base plate 61 has a metallization layer 614 at its central portion for receiving a semiconductor chip 2, and a metallization line 615 is directed from the metallization layer 614 to a respective one of the metallization lines 613a or 613b.

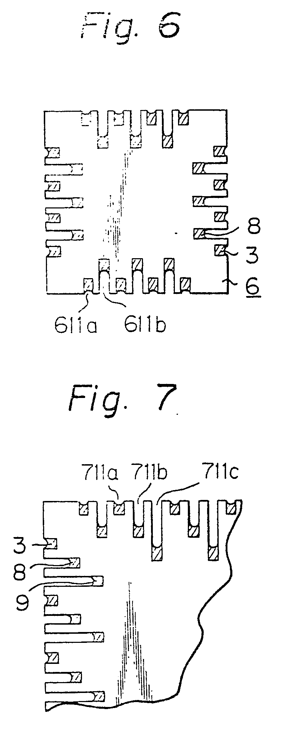

On the surface of the grooves 611a, 611b, 621a and 621b, metallization lines 613a, 613b, 623a and 623b are also formed and are connected to radial metallization lines 625 formed on the surface of the intermediate plate 62 and metallization layers or soldering pads 3 and 8 (Fig. 6) formed on the underside of the base plate 61. The soldering pads have a width of 0.4 mm and a length of 0.4 mm.

In this example, although the pitch of the grooves 611 and 621 is 0.635 mm, the space between the adjacent soldering pads 3 and 8 is longer than 0.87 mm, which is as long as the space between the adjacent soldering pads 3 of the above-described prior art example having a larger pitch. Therefore, by use of the invention it is possible to increase the number of soldering pads for a given package size without increasing the risk of short circuits by solder bridges.

In the above embodiment two sets of grooves of different depths are used. However, three or more sets of different depths of grooves may be used for the same purpose. Fig. 7 shows an example of an arrangement having three sets of grooves 711a, 711b and 711c and corresponding soldering pads 3, 8 and 9.

The metallization layers and/or the soldering pads may be formed of tungsten, and the layers and/or the pads may be covered with a layer of gold or nickel.

**Claims**

1. A semiconductor device comprising a semiconductor chip (2); a·ceramic base (6) carrying the semiconductor chip thereon and having a plurality of grooves (611a, 611b, 621a, 621b) spaced apart along the edge face (612, 622) of the ceramic base; a respective metallization line (613a, 613b, 623a, 623b) formed on the wall of each groove and electrically connected to the chip; and a plurality of soldering pads (3, 8) formed on the underside of the ceramic base and electrically connected to the metallization lines; characterised in that adjacent grooves have different depths measured from the edge face of the ceramic base.

2. A device according to Claim 1, characterised in that the grooves are of two different depths, grooves (611a, 621a) of one depth being arranged alternately with grooves (611b, 621b) of the other depth.

3. A device according to Claim 1 or Claim 2, characterised in that the ceramic base (6) is of alumina.

4. A device according to any preceding claim, characterised in that the metallization lines (613a, 613b, 623a, 623b) are covered with a plated layer.

5. A device according to any preceding claim, characterised in that the soldering pads (3, 8) are covered with a plated layer.

6. A device according to any preceding claim, characterised in that the metallization lines (613a, 613b, 623a, 623b) and the soldering pads (3, 8) are of tungsten.

7. A device according to Claim 6, characterised in that the metallization lines (613a, 613b, 623a, 623b) of tungsten are covered with a gold layer.

8. A device according to Claim 6, characterised in that the metallization lines (613a, 613b, 623a, 623b) of tungsten are covered with a nickel layer.

9. A device according to Claim 6, Claim 7 or Claim 8, characterised in that the soldering pads (3, 8) of tungsten are covered with a gold layer.

10. A device according to Claim 6, Claim 7 or Claim 8, characterised in that the soldering pads (3, 8) of tungsten are covered with a nickel layer.

**Patentansprüche**

1. Halbleitervorrichtung mit einem Halbleiterchip (2); einer keramischen Basis (6), die das Halbleiterchip trägt und eine Vielzahl von Nuten (611a, 611b, 621a, 621b), die mit Abstand längs der Randfläche (612, 622) der keramischen Basis angeordnet sind; einer jeweiligen Metallisierungsleitung (613a, 613b, 623a, 623b), die auf der Wand jeder Nut gebildet und elektrisch mit dem Chip verbunden ist; und einer Vielzahl von Lötpads (3, 8), die auf der Unterseite der keramischen Basis gebildet sind und elektrisch mit den Metallisierungsleitungen verbunden sind; dadurch gekennzeichnet, daß benachbarte Nuten verschiedene Tiefen haben, gemessen von der Randfläche der keramischen Basis.

2. Vorrichtung nach Anspruch 1, dadurch gekennzeichnet, daß die Nuten von zwei verschiedenen Tiefen sind, Nuten (611a, 621a) von einer Tiefe, die alternativ mit Nuten (611b, 621b) der anderen Tiefe angeordnet sind.

3. Vorrichtung nach Anspruch 1 oder 2, dadurch gekennzeichnet, daß die keramische Basis (6) aus Aluminiumoxid besteht.

4. Vorrichtung nach einem der vorhergehenden Ansprüche, dadurch gekennzeichnet, daß die Metallisierungsleitungen (613a, 613b, 623a, 623b) mit einer plattierten Schicht bedeckt sind.

5. Vorrichtung nach einem der vorhergehenden Ansprüche, dadurch gekennzeichnet, daß die Lötpads (3, 8) mit einer plattierten Schicht bedeckt sind.

6. Vorrichtung nach einem der vorhergehenden Ansprüche, dadurch gekennzeichnet, daß die Metallisierungsleitungen (613a, 613b, 623a, 623b) und die Lötpads (3, 8) aus Wolfram bestehen.

7. Vorrichtung nach Anspruch 6, dadurch gekennzeichnet, daß die Metallisierungsleitungen (613a, 613b, 623a, 623b) aus Wolfram mit einer Goldschicht bedeckt sind.

8. Vorrichtung nach Anspruch 6, dadurch gekennzeichnet, daß die Metallisierungsleitung (613a, 613b, 623a, 623b) aus Wolfram mit einer Nickelschicht bedeckt sind.

9. Vorrichtung nach einem der Ansprüche 6, 7 oder 8, dadurch gekennzeichnet, daß die Lötpads (3, 8) aus Wolfram mit einer Goldschicht bedeckt sind.

10. Vorrichtung nach Anspruch 6, 7 oder 8, dadurch gekennzeichnet, daß die Lötpads (3, 8) aus Wolfram mit einer Nickelschicht bedeckt sind.

**Revendications**

1. Dispositif semiconducteur comprenant: une puce semiconductrice (2); une base en céramique (6) portant la puce semiconductrice et possédant plusieurs encoches (611a, 611b, 621a, 621b) mutuellement séparées le long de la face de bord (612, 622) de la base en céramique; une ligne de métallisation respective (613a, 613b, 623a, 623b) formée sur la paroi de chaque encoche et électriquement connectée à la puce; et plusieurs plots de soudage (3, 8) formés sur l'envers de la base en céramique et électriquement connectés aux lignes de métallisation, caractérisé en ce que des encoches adjacentes possèdent des profondeurs différentes, celles-ci étant mesurées à partir de la face de bord de la base en céramique.

2. Dispositif selon la revendication 1, caractérisé en ce que les encoches présentent deux profondeurs différentes, les encoches (611a, 621a) ayant une première profondeur étant disposées en alternance avec les encoches (611b, 621b) ayant l'autre profondeur.

3. Dispositif selon la revendication 1 ou 2, caractérisé en ce que la base en céramique (6) est faite d'alumine.

4. Dispositif selon l'une quelconque des revendications précédentes, caractérisé en ce que les lignes de métallisation (613a, 613b, 623a, 623b) sont recouvertes d'une couche plaquée.

5. Dispositif selon l'une quelconque des revendications précédentes, caractérisé en ce que les plots de soudage (3, 8) sont recouverts d'une couche plaquée.

6. Dispositif selon l'une quelconque des revendications précédentes, caractérisé en les lignes de métallisation (613a, 613b, 623a, 623b) et les plots de soudage (3, 8) sont en tungstène.

7. Dispositif selon la revendication 6, caractérisé en ce que les lignes de métallisation (613a, 613b, 623a, 623b) en tungstène sont recouvertes d'une couche d'or.

8. Dispositif selon la revendication 6, caractérisé en ce que les lignes de métallisation (613a, 613b, 623a, 623b) en tungstène sont recouvertes d'une couche de nickel.

9. Dispositif selon la revendication 6, 7 ou 8, caractérisé en ce que les plots de soudage (3, 8) en tungstène sont recouverts d'une couche d'or.

10. Dispositif selon la revendication 6, 7 ou 8, caractérisé en ce que les plots de soudage (3, 8) en tungstène sont recouverts d'une couche de nickel.

*Fig. 1*

*Fig. 2*

1

*Fig. 3*

*Fig. 4*

*Fig. 5*

## Fig. 6

8
3
6

611a    611b

## Fig. 7

711a  711b    711c

3
8
9